# EUROPEAN PATENT SPECIFICATION

(11) **EP 1 897 189 B1**
(45) Date of publication and mention of the grant of the patent: **18.01.2017**
(21) Application number: 06799989.6
(22) Date of filing: 29.06.2006
(51) Int. Cl.: H01S 5/14, H01S 5/0683

(54) **INTEGRATED MONITORING AND FEEDBACK DESIGNS FOR EXTERNAL CAVITY TUNABLE LASERS**
INTEGRIERTE ÜBERWACHUNGS- UND RÜCKKOPPLUNGSKONSTRUKTIONEN FÜR ABSTIMMBARE LASER MIT EXTERNEM RESONATOR
CONCEPTIONS DE SURVEILLANCE ET DE RETROACTION INTEGREES POUR LASERS ACCORDABLES A CAVITE EXTERNE

(30) Priority: 30.06.2005 US 173777
(43) Date of publication of application: 12.03.2008
(73) Proprietor: Intel Corporation, Santa Clara, CA 95052 (US)
(72) Inventor: HUTCHINSON, John, M., Santa Barbara, CA 93111 (US); DAIBER, Andrew, J., Emerald Hills, CA 94062 (US); MCDONALD, Mark, E., Milpitas, CA 95035 (US); NIKONOV, Dmitri, E., Morgan Hill, CA 95037 (US)
(74) Representative: Rummler, Felix
(86) International application number: PCT/US2006/025754
(87) International publication number: WO 2007/005700

(56) References cited:
- WO-A2-02/13343
- US-A- 5 673 129
- US-A1- 2002 054 614
- US-A1- 2002 075 918
- US-A1- 2005 053 103
- US-B1- 6 822 996

## Description

### BACKGROUND

### Field

Embodiments of the invention relate to the field of lasers and more specifically, but not exclusively, to integrated monitoring and feedback designs for external cavity tunable lasers.

### Background Information

Optical transmission systems are used in telecommunication and enterprise networks to transfer data and/or voice communications. Optical signals provide high-speed, superior signal quality, and minimal interference from outside electro-magnetic energy. Optical networks utilizing Dense Wavelength Division Multiplexed (DWDM) systems offer multi-channel optical links.

Optical networks often include transmitters, such as lasers. A laser commonly used today is an external cavity tunable laser. The optical signal from a laser may be modulated with a data signal and the modulated optical signal sent onto an optical network. The performance of lasers may be affected by numerous factors, such as manufacturing variations, changes in environmental temperature and aging of the laser components. In order to tolerate and compensate for the variations in performance due to these factors, laser monitoring and feedback systems are used.

US 2002/0075918 discusses an open loop controller for use with a sampled grating distributed Bragg reflector laser.

According to one aspect, the present invention provides an apparatus as set out in claim 1.

### BRIEF DESCRIPTION OF THE DRAWINGS

Non-limiting and non-exhaustive embodiments of the present Invention are described with reference to the following figures, wherein like reference numerals refer to like parts throughout the various views unless otherwise specified.
Figure 1 is a block diagram of an example of an external cavity tunable laser having integrated monitoring and feedback.
Figure 2 is a block diagram of an example of an external cavity tunable laser having integrated monitoring and feedback.
Figure 2B is a block diagram of a waveguide.
Figure 3 is a block diagram of an external cavity tunable laser having integrated monitoring and feedback in accordance with one embodiment of the present invention.
Figure 3B is a block diagram of a modulator in accordance with one embodiment of the present invention.
Figure 4 is a block diagram of a laser output monitor in accordance with one embodiment of the present invention.
Figure 4B is a block diagram of a laser output monitor in accordance with one embodiment of the present invention.
Figure 4C is a graph illustrating the optical power at a laser output monitor in accordance with one embodiment of the present invention.
Figure 4D is a graph illustrating the optical power of a laser output after being tapped by a laser output monitor in accordance with one embodiment of the present invention.
Figure 5 is a block diagram of a mode filter in accordance with one embodiment of the present invention.
Figure 5B is a graph illustrating the performance of a mode filter in accordance with one embodiment of the present invention.
Figure 5C is a graph of the performance of a mode filter in accordance with one embodiment of the present invention.
Figure 6 is a mask layout of an integrated structure in accordance with one embodiment of the present invention.
Figure 7 is a block diagram of an external cavity tunable laser having integrated monitoring and feedback in accordance with one embodiment of the present invention.
Figure 8 is a block diagram of a system including an external cavity tunable laser having integrated monitoring and feedback in accordance with one embodiment of the present invention.

### DETAILED DESCRIPTION

In the following description, numerous specific details are set forth to provide a thorough understanding of embodiments of the invention. One skilled in the relevant art will recognize, however, that embodiments of the invention can be practiced without one or more of the specific details, or with other methods, components, materials, etc. In other instances, well-known structures, materials, or operations are not shown or described in detail to avoid obscuring understanding of this description.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

A method to perform monitoring and feedback is to incorporate a discrete optical beamsplitter (to split off a fraction of the laser light) and photodiode to convert the optical power into an electrical signal, which can be fed back to the laser and vary an input to the laser in order to maintain a constant power, wavelength or other laser performance metric. These feedback mechanisms require several discrete piece parts, such as the beamsplitter and photodiode to be precisely aligned and affixed to the laser assembly (a "hybrid" approach) which are physically larger, difficult to automate, expensive and may vary due to the same environmental and aging conditions which affect the laser itself. Embodiments described herein include monolithically integrated feedback and control systems for a laser. Such systems provide smaller form factors and offer a less expensive final assembly process.

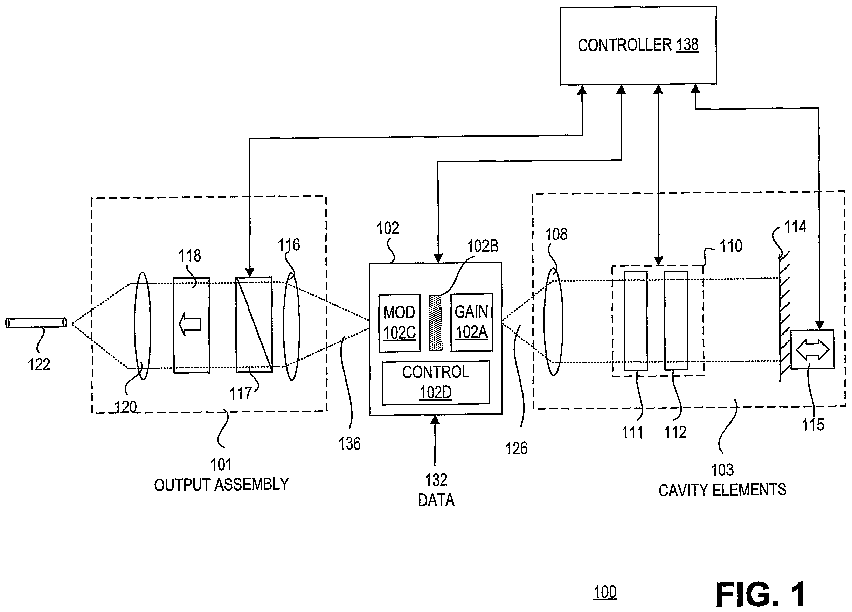

Turning to Figure 1, an example of a laser 100 having integrated feedback and monitoring is shown. As will be discussed below, laser 100 is structured similarly to an External Cavity Diode Leaser (ECDL). Laser 100 includes cavity elements 103 optically coupled to an integrated structure 102. Integrated structure 102 is optically coupled to an output assembly 101. A controller 138 may be coupled to integrated structure 102, cavity elements 103, output assembly 101, or any combination thereof. Controller 138 may include a conventional processor to receive and send control signals to components of laser 100.

Integrated structure 102 includes a gain section 102A, a reflector 102B, a modulator 102C, and a control section 102D. In this example, integrated structure 102 includes components such as gain section 102A, reflector 102B, modulator 102C, and control section 102D that are formed on one or more semiconductor substrates. Examples herein include a "monolithically" integrated structure 102 where components of integrated structure 102 are formed on a single semiconductor substrate. In another example, integrated structure 102 may be packaged for mounting to a printed circuit board.

Gain section 102A emits an optical beam 126 that is collimated by lens 108. Light from optical beam 126 is reflected from reflector 114 back to gain 102A and to reflector 102B. Reflector 102B is partially-reflective. The cavity of laser 100 is defined by reflector 102B and reflector 114.

Modulator 102C modulates an optical signal produced by laser 100 using data 132. In general, control section 102D provides monitoring of various parameters of laser 100 and may be used in providing feedback to components of laser 100. Embodiments of control section 102D will be discussed below.

Cavity elements 103 include reflector 114, a tuner 110, and lens 108. Reflector 114 may include a reflector, grating, prism, or the like. In another example, reflector 114 may be curved such that lens 108 may be eliminated.

The basic operation of laser 100 is as follows. A controllable current is supplied to gain section 102A which produces an emission of optical energy. The emitted optical energy passes back and forth between reflector 102B and reflector 114. As the optical energy passes back and forth, a plurality of resonances, or "lasing" modes are produced. Under a tasting mode, a portion of the optical energy temporarily occupies the external laser cavity; at the same time, a portion of the energy in the external laser cavity eventually passes through partial reflector 102B. The energy that exits the laser cavity through the partial reflector 102B results in optical output 136.

Optical output 136 passes through output assembly 101 and into an optical fiber 122. Optical beam 136 is collimated by lens 116 and focused by lens 120. In one example, an optical isolator 118 is positioned between lens 116 and lens 120. In one example, optical isolator 118 prevents reflections from returning toward integrated structure 102. Optical beam 136 is focused by lens 120 into optical fiber 122. In one example, optical fiber 122 is supported by a ferrule (not shown).

In an example, a beam splitter 117 is positioned between lens 116 and 120 to pick off a portion of optical beam 136 such that the intensity of the split-off portion can be measured by a photo-electric device, such as a photodiode. The intensity measured by the photodiode is proportional to the intensity of the output beam. The measured intensity may then be sent to controller 138. Controller 138 may use this signals to make adjustments to other components of laser 100 to maximize or stabilize the optical output power.

Tuner 110 may be used to tune the wavelength of the optical signal outputted by laser 100. In one example, laser 100 may be tuned to C-band wavelengths (1530-1570 nm). Tuner 110 may also be referred to as a wavelength filter. In one example, tuner 110 is tuned using control signals from controller 138. In another example, tuner 110 includes a thermal tuner. In this particular example, by adjusting the heat to at least a portion of turner 110, the optical characteristics of tuner 110 are changed to tune the laser to various wavelengths.

It will be appreciated that other methods of tuning laser 100 may be used to change the output wavelength of laser 100. In one example, the output of tunable laser 100 may be tuned by adjusting the length of the laser cavity by moving reflector 114 through thermal or mechanical mechanism. Figure 1 shows an actuator 115 couplet to controller 138 that may physically move reflector 114. In other examples, tunable laser 100 may be tuned by mechanically or thermally adjusting one or more etalons positioned in optical beam 126. In another example, laser 100 may be tuned by changing the refractive index of gain medium 102A through thermal control. In other example, laser 100 may be tuned through acausto-optics, electro-optics, or the like.

In one example, tuner 110 includes etalon 111 and etalon 112 to tune laser 100 using Vernier tuning. In order to produce an output at a single frequency, filtering mechanisms are employed to substantially attenuate all lasing modes except for the lasing mode corresponding to the desired wavelength. Etalon 111 may act as a grid generator and etalon 112 may act as a channel selector. A grid generator, which may comprise an etalon that operates as a Fabry-Perot resonator, defines a plurality of transmission peaks (also referred to as passbands). Ideally, during operation the transmission peaks remained fixed; in practice, it may be necessary to employ a servo loop (*e.g.*, a temperature control loop) to maintain the transmission peaks of the grid generator at the desired location. Since the cavity length for the grid generator is less than the cavity length for the laser cavity, the spacing (in wavelength) between the transmission peaks is greater for the grid generator than that for the cavity modes. Generally, the location and spacing of the transmission peaks for the grid generator will correspond to a set of channel frequencies defined by the communication standard the laser is to be employed for, such as the International Telecommunication Union (ITU) channels. Furthermore, the spacing of the transmission peaks corresponds to the free spectral range (FSR) of the grid generator.

A channel selector, such as etalon 112, is employed to select the lasing mode of the laser output. For illustrative purposes, etalon 112 may comprise an etalon having a width substantially less than etalon 111 used for the grid generator. In this case, the FSR of the channel selector is substantially larger than that of the grid generator; thus the bandpass waveform of the channel selector is broadened. In accordance with the Vernier tuning technique, a desired wavelength (*i.e.,* channel) may be selected by aligning the single transmission peak of the channel selector with one of the transmission peaks of the grid generator.

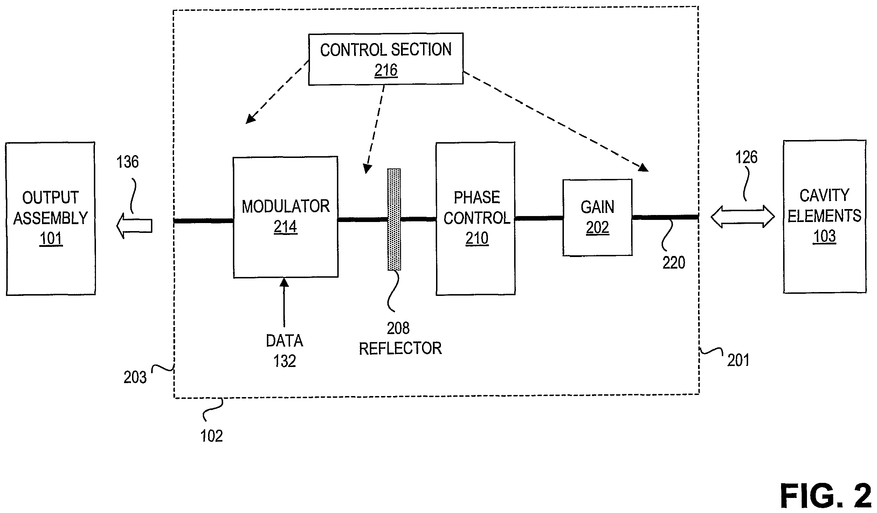

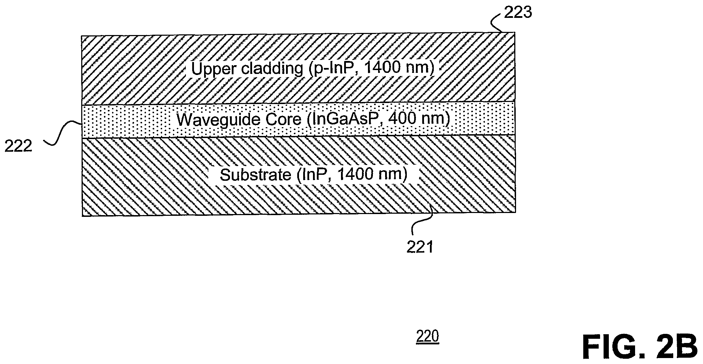

Turning to Figure 2, an example of integrated structure 102 is shown. Integrated structure 102 includes a gain section 202, a reflector 208, and a modulator 214 optically coupled by a waveguide 220. In one example, waveguide 220 is a semiconductor waveguide. Integrated structure 102 may optionally include a phase control 210 between gain 202 and reflector 208 (as shown in Figure 2), or between gain 202 and front facet 201.

Optical beam 126 passes through integrated structure 102 via waveguide 220. Integrated structure 102 includes a front facet 201 and a rear facet 203 connected by waveguide 220. In one example, facets 201 and 203 are non-reflective. Reflector 114 of cavity elements 103 and reflector 208 define the external cavity. Light beam 136 exits waveguide 220 and enters output assembly 101. Laser output exiting reflector 208 is modulated by modulator 214 using data 132.

Different techniques for monolithic integration of a gain section, modulator section, and optional phase control within an integrated device 102 have been developed. To minimize the absorption in the phase- and (unbiased) modulator sections the band-gap of these sections may be broadened by approximately 0.06-0.12 eV (blue shift of the absorption peak by 100-200 nm) compared to the gain section. This can be done by one of the following techniques. In each of the techniques, the integrated structure comprises a material suitable for forming applicable energy bandgaps. In one embodiment, the integrated structure is formed using an Indium Gallium Arsenic Phosphide (InGaASP) based material.

A first technique uses an offset Quantum-Well (QW) structure. In this structure, the multiple quantum-well active layer is grown on top of a thick low band-gap (0.84-0.9 eV) quaternary waveguide. The two layers are separated by a thin (about 10 nm) stop etch layer to enable the QW's to be removed in the phase and modulator sections with selective etching. This low bandgap waveguide provides high index shift for the phase section of the laser at low current densities. The modulator section uses the same waveguide structure as the phase section with a reverse voltage applied to the electrodes.

A second technique, known as Quantum Well Intermixing (QWI), relies on impurity or vacancy implantation into the QW region allowing its energy bandgap to be increased. Selective application of QWI to the phase control and modulator sections provides the required blue shift of the absorption peak of about 100-200 nm. This technique allows for better mode overlap with the quantum wells than the first technique.

A third technique employs asymmetric twin-waveguide technology where two optical functions of amplification and modulation (phase control) are integrated in separate, vertically coupled waveguides, each independently optimized for the best performance.

In the modulator, the bulk waveguide material provides a wider spectral bandwidth than would be possible with a QW structure. Therefore, for widely tunable ECDL applications the first technique and the third technique with a bulk material in the modulator/ phase section waveguide should provide better results than the QWI technique.

Integrated structure 102 includes one or more control sections 216. In one embodiment, control section 216 may be placed along various positions along waveguide 220, as shown be the dashed-line arrows. Various embodiments of control section 216 will be discussed below. In one embodiment, components of integrated structure 102, including control section 216, may be fabricated using well-known semiconductor fabrication techniques.

In one example, reflector 208 is formed by etching an air gap of a controlled width. In another example, reflector 208 may include a chirped Bragg grating. Such a chirped Bragg grating using a grating structure similar to a Distributed Bragg Reflector (DBR) laser, except the grating is unevenly spaced (i.e., chirped) so as to produce multiple resonant modes.

In one example, integrated structure 102 includes phase control section 210 for wavelength locking of laser 100. Under this technique, a "dither" or modulation signal is supplied to cause a corresponding modulation in the optical path length of the portion of the waveguide passing through phase control section 210, and thus modulate the optical path length of the laser cavity. This produces a modulated phase-shift effect, resulting in a small modulation of the optical frequency (FM) of the lasing mode. Intracavity or external Optical elements can act as transducers to produce modulation of the intensity (power) of the output beam, also referred to as amplitude modulation, corresponding to the optical FM.

The imposed modulation or "dither" may be detected in the output beam of the laser and analyzed to determine the wavelength offset (direction and magnitude) of the lasing mode from the desired wavelength.

Turning to Figure 2B, a cut-away side view of waveguide 220 in the region of modulator 214 and optional phase control 210 is shown. A waveguide core 222 is formed on a substrate 221. In one example, substrate layer 221 includes Indium Phosphide (InP) and waveguide core 222 includes Indium Gallium Arsenic Phosphide (InGaAsP). In another example, waveguide core 222 includes Indium Gallium Aluminum Arsenic (InGaAIAs).

In the example of Figure 2B, substrate 221 has a thickness of approximately 1400 nanometers (nm) and waveguide core 222 has a thickness of approximately 400 nm and a width of approximately 370-470 nm. An upper cladding layer 223 is formed over waveguide core 222. In one embodiment, upper cladding layer 223 includes p-type InP having a thickness of approximately 1400 nm.

It will be appreciated that other components of integrated structure 102, such as gain section 202, may be formed on substrate 221 using well known techniques described earlier.

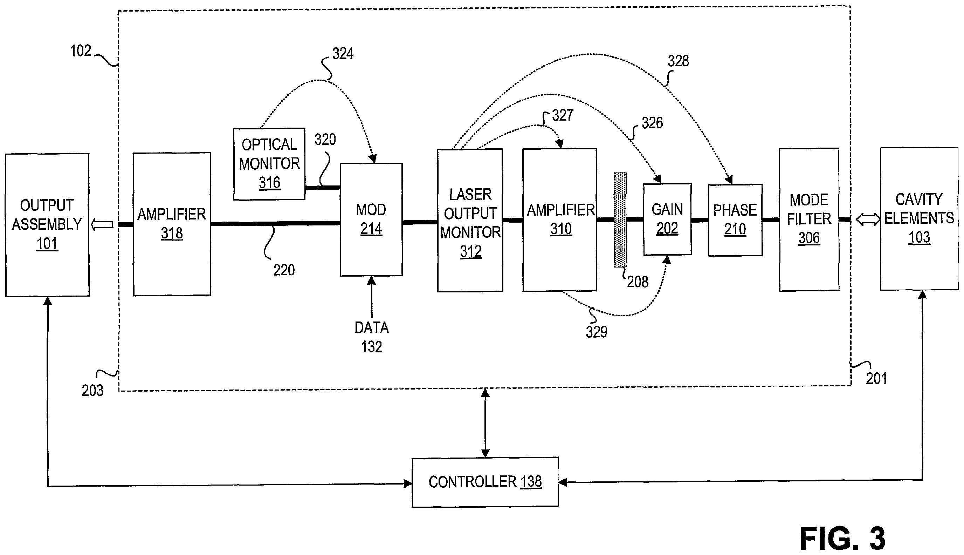

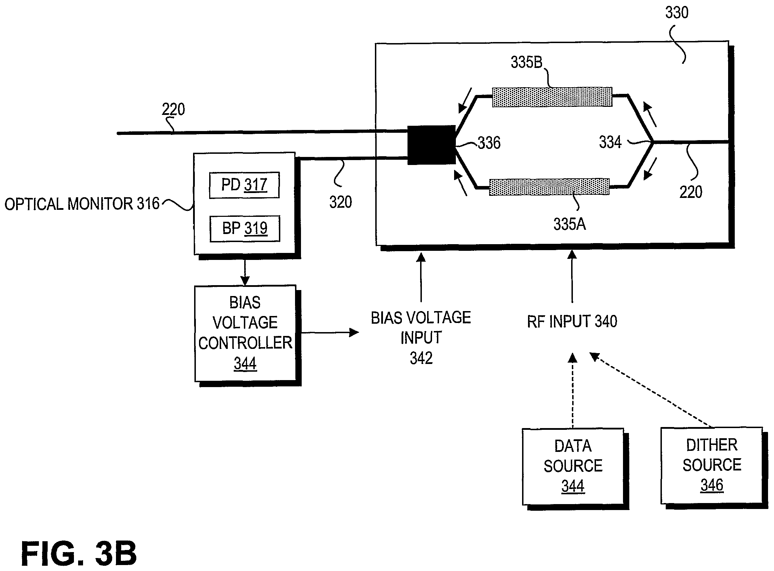

Turning to Figure 3, an embodiment of integrated structure 102 is shown. Figure 3 shows embodiments of various control sections of integrated structure 102. Embodiments of a control section include a mode filter 306, an amplifier 310, a laser output monitor 312, an optical monitor 316 of suitable bandwidth for dither signal capture, and an amplifier 318. It will be understood that embodiments of integrated structure 102 do not necessarily include all the control sections discussed herein, but may include any combination thereof.

Figure 3 also shows a controller 138 coupled to output assembly 101, cavity elements 103, and integrated section 102. As described below, embodiments of control sections monitor aspects of laser 100 as part of laser control. In some embodiments, these control sections measure an aspect of the laser and generate a monitor signal based on that measurement. As describe further below, this monitoring may be used to form a feedback signal for a component of the laser.

In one embodiment, a monitoring signal may be sent back to a laser component directly from a control section for corrective action by the component. In this particular embodiment, a feedback signal includes the monitoring signal.

In another embodiment, monitoring signals may pass through controller logic of integrated structure 102 (an "on-chip" controller) that uses the signal to send control signals to a laser component. In yet another embodiment, the monitoring signals from a control section may be sent to an "off-chip" controller, such as controller 138, which provides control signals to laser 100 based on information received from the control section. In one embodiment, the combination of a monitoring signal and a control signal forms a feedback signal for a laser component.

In one embodiment of a control section, amplifier 310 is positioned between reflector 208 and modulator 214 along waveguide 220. In one embodiment, amplifier 310 includes a Semiconductor Optical Amplifier (SOA). In one embodiment, amplifier 310 may be used to provide constant optical power output across a wavelength range. When an SOA is forward biased, the SOA amplifies the power of the light traveling in waveguide 220. When an SOA is reversed biased, the SOA substantially absorbs the power of the light traveling in waveguide 220. Thus, in one embodiment, amplifier 310 may provide dual functionality from a single device.

In another embodiment, amplifier 310 may act as an optical attenuator or shutter to absorb some or nearly all of the laser light output. During wavelength switching, the optical output may be blanked so that transient optical signals are not sent to modulator 214 and subsequent optical output assembly 101.

In yet another embodiment, amplifier 310 may be used to optimize the power of the optical signal sent to modulator 214. Modulator 214, such as a Mach-Zehnder Modulator (MZM), may have a better extinction ratio at particular power levels of the optical signal to be modulated. The extinction ratio is a ratio between the amplitude of an optical "high" and an optical "low" that are interpreted as logical 1's and 0's. Amplifier 310 may be used to adjust the optical output of the laser to a power level that results in a desired extinction ratio of modulator 214.

Another embodiment of a control section of integrated structure 102 includes laser output monitor 312 optically coupled between reflector 208 and modulator 214 by waveguide 220. Laser output monitor 312 measures the power of the laser output. The detected output power may be used to make adjustments to components of the laser. In one embodiment, monitoring by laser output monitor 312 may be used as feedback 326 for control of gain 202. In another embodiment, laser output monitor 312 may be used to control amplifier 310 using feedback 327. In this particular embodiment, feedback 327 may be used to control amplifier 310 to maintain a constant power output at all wavelengths.

In another embodiment, laser output monitor 312 may be used to control phase control 210. In this embodiment, feedback 328 may be used to maintain an optical cavity length of the laser and hence maintain a desired output wavelength.

In one embodiment, laser output monitor 312 may be implemented using a photo-detector, such as reverse biased passive waveguide photodiode. The current generated by the photodiode is proportional to the optical output power of the laser. This current may be used as feedback for control of gain 202 or phase control 210.

In another embodiment, amplifier 310 may also be used as a laser output monitor. In constant current mode, an SOA may generate a voltage that is proportional to the optical output power of the laser. This generated voltage may be used to evaluate the output power performance of the laser and to generate optical power feedback 329 to gain 202 so that gain 202 may be adjusted to optimize the optical output power of the laser.

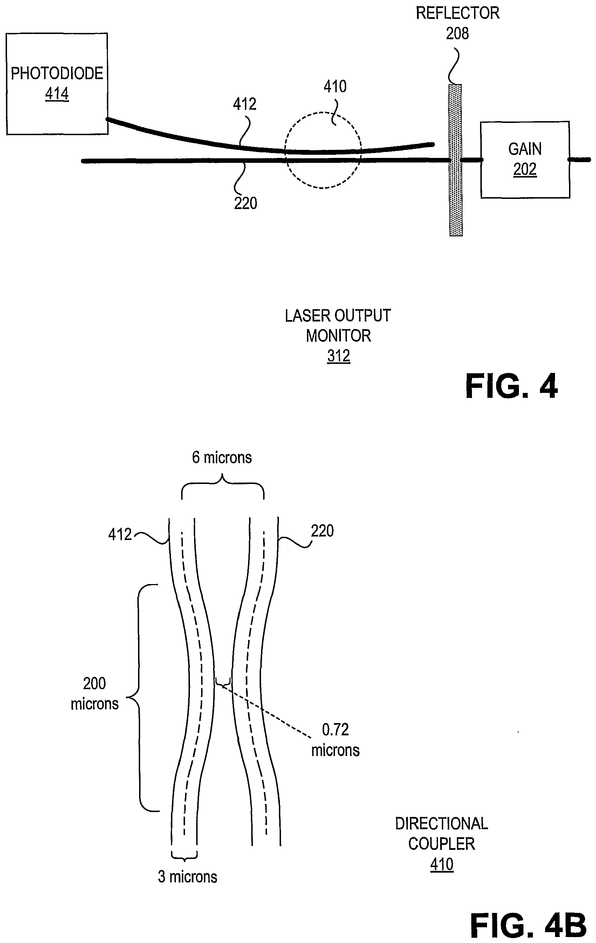

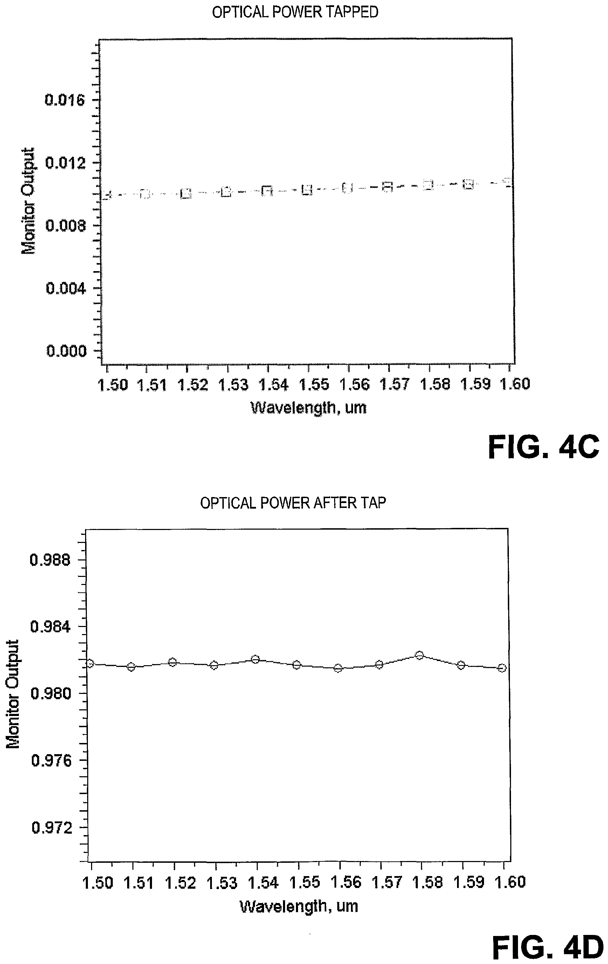

Referring to Figures 4 and 4B, an embodiment of laser output monitor 312 includes a directional coupler 410. In Figure 4, a waveguide 412 is formed next to waveguide 220. Directional coupler 410 is formed by the proximity of waveguide 412 to waveguide 220.

In one embodiment, waveguide 412 taps off a small portion of the optical signal passing through waveguide 220. Because of the proximity of waveguide 412 to waveguide 220, a small portion of light from waveguide 220 will be transferred to waveguide 412. The intensity profile (e.g., Gaussian mode) of an optical signal in waveguide 220 extends beyond waveguide 220 such that a portion of the optical signal may be "picked off" by waveguide 412.

In one embodiment, directional coupler 410 taps off 1% of the optical signal in waveguide 220. The tapped off optical signal may be sent along waveguide 412 to a photodiode 414. Photodiode 414 may be used to determine the optical power of the tapped off signal, and this information may be returned to gain 202 as output power feedback 326.

Figure 4B shows a top view of an embodiment of directional coupler 410. Waveguides 220 and 412 are 3 microns wide. The effective coupling area between waveguides 220 and 412 is approximately 200 microns long. Waveguides 220 and 412 are formed to be within 0.72 microns of each other at a coupling area.

Testing has shown that a directional coupler is wavelength insensitive across a wavelength band of interest; the directional coupler taps off approximately the same amount of optical output power at various wavelengths. For example, the directional coupler as shown in Figure 4B was tested over C-band wavelengths. Figure 4C shows that 1% of optical output power was tapped off across wavelengths of 1500-1600 nm into waveguide 412. Figure 4D shows that the resulting optical output power in waveguide 220 after the tap-off remained around 98.2% across the same range of wavelengths. Thus, directional coupler 410 provides a passive output power detector with minimal optical loss across a range of wavelengths.

Returning to Figure 3, another embodiment of a control section includes optical monitor 316. Optical monitor 316 is used to monitor the output of modulator 214. Optical monitor 316 is optically coupled to modulator 214 by waveguide 320. In one embodiment, modulator 214 produces both an optical data signal and a complementary optical data signal. The complementary optical data signal is an inverted form of the modulated signal coupled to waveguide 220.

Turning to Figure 3B, an embodiment of an MZM 330 is shown. An optical signal enters MZM 330 along waveguide 220. The optical signal is equally split by splitter 334 into two waveguides. In one embodiment, splitter 334 includes a Y-junction. In another embodiment, splitter 334 is implemented as a Multi-Mode Interferometer (MMI).

The optical signal is recombined at combiner 336 and output into waveguide 220. A complementary optical data signal is output into waveguide 320. Embodiments of combiner 336 include a Y-junction, an MMI, or the like.

Electrodes 335A and 335B are used to affect the modulation of the optical signal. A voltage applied to the semiconductor of MZM 330 induces a change in the index of refraction of the material. In one state, such as when a voltage is not applied to electrodes 335A, 335B, the optical signals re-combined at combiner 336 are in-phase and interfere constructively. In this case, optical output is "high" and may be recognized as a logical "1."

In a second state, such as when a voltage is applied to electrode 335A or 335B, the index of refraction of the semiconductor material changes, causing a phase shift between the two arms of MZM 330. When the optical signals recombine at combiner 336, destructive interference occurs leading to a "low" optical signal that may be interpreted as a logical "0."

MZM 330 also includes an RF input 340. An RF input signal may be applied to electrodes 335A, 335B to induce the modulation of the optical signal from waveguide 220. The RF input signal includes a data signal from data source 344 and a dither signal from dither source 346.

In one embodiment, RF input signal should be applied at the quadrature point of the MZM transfer function. The bias point of MZM 330 may be controlled by a bias voltage at bias voltage input 342. In one embodiment, the bias voltage is applied to the substrate of the integrated device 221. In another embodiment, the bias voltage is combined with the RF voltage input 340 which is applied to the MZM electrodes 335A, 335B.

The MZM transfer function may shift to the left or right due to environmental temperature changes or aging of the MZM. This may result in poor optical output quality because the RF input signal is no longer being applied at a quadrature point. This may result in a poor extinction ratio. A bias voltage is used to compensate for the drift of MZM 330.

In one embodiment, an Amplitude Modulated (AM) dither is used as a feedback mechanism for adjusting the bias voltage. In the AM dither technique, the amplitude of the RF input signal is modulated by a low frequency signal, referred to as a dither. The amplitude of the dither is much smaller than the amplitude of the RF input signal so that the dither will not adversely affect the optical output of the MZM.

The dither is recovered from the complementary data optical signal by optical monitor 316. In one embodiment, the complementary optical data output may be absorbed by photodiode 317 to provide a bias error signal to bias voltage controller 344. In one embodiment, the dither signal is recovered by using a band-pass filter 319, in optical monitor 316, to extract only the dither frequency from the modulated data stream. The band-pass filter may be used to effectively average over data-rate variations of optical power.

Bias voltage controller 344 makes adjustments to the bias voltage input signal based on the error signal received from optical monitor 316. As described above, bias voltage controller 344 may be "on-chip" or "off-chip" as to integrated structure 102.

In another embodiment, photodiode 317 is constructed on output waveguide 220 and is biased to be partially absorbing such that the majority of the modulated output signal is passed on to output assembly 101, and the balance of the output signal is converted into a photocurrent for feedback via bias voltage controller 344.

Returning to Figure 3, another embodiment of a control section is amplifier 318 optically coupled between modulator 214 and optical output assembly 101 along waveguide 220. In one embodiment, amplifier 318 includes an SOA.

In one embodiment, amplifier 318 may be used to compensate for optical power loss in modulator 214.

In another embodiment, amplifier 318 may also be used as a blanker. In this particular embodiment, amplifier 318 may be used as a blanker during wavelength transitions, so that laser output monitoring may continue to be done by laser output monitor 312 during wavelength transitions. In the embodiment of Figure 3, if amplifier 310 is being used as a blanker, then the monitoring capabilities of laser output monitor 312 are lost during blanking by amplifier 310 because laser output monitor 312 is not receiving the laser output.

In another embodiment, a control section of integrated structure 102 may include mode filter 306. Mode filter 306 is positioned between gain 202 and cavity elements 103 along waveguide 220. Mode filter 306 is used to filter out undesirable modes from being output by the laser.

One embodiment of mode filter 306 includes a bent waveguide. Bending the waveguide across a radius increases the loss of higher order modes. By increasing the loss of the higher order modes in the waveguide, lasing instabilities due to these undesirable modes are suppressed.

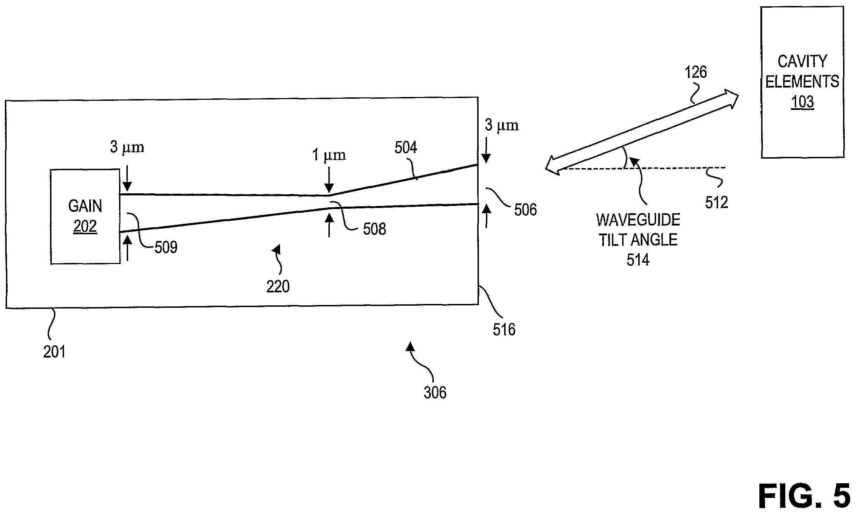

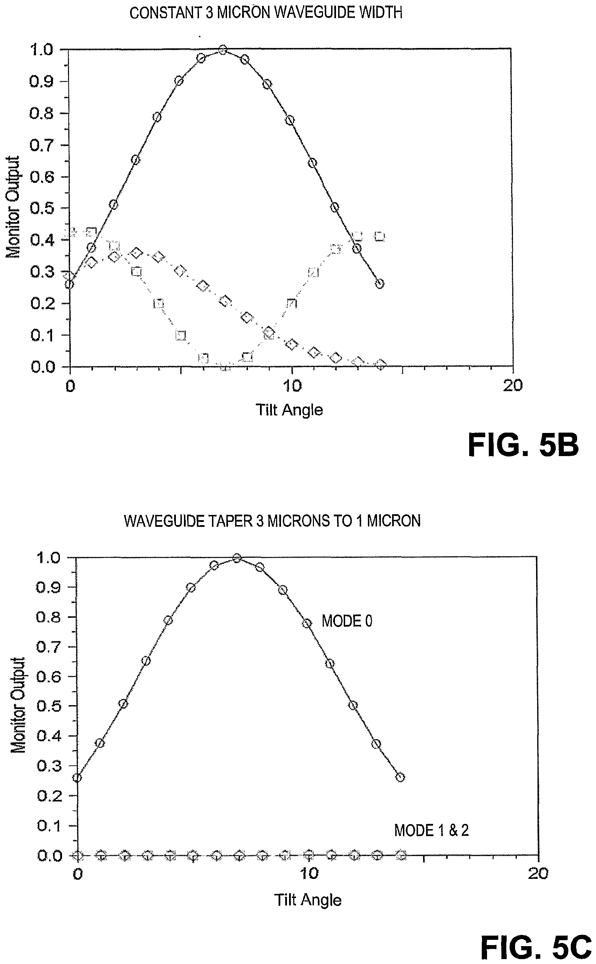

In another embodiment, mode filter 306 includes a tapered waveguide section 504 as shown in Figure 5. The optimum shape of the optical mode in waveguide 220 may be different from the optimum shape of the optical mode of cavity elements 103. The tapered waveguide section 504 of waveguide 220 improves the alignment tolerance and resulting chirp alignment sensitivity arising from the coupling of external cavity modes to the mode propagated in waveguide 220.

In Figure 5, waveguide 220 includes tapered waveguide section 504. Tapered waveguide section 504 includes a wide end 506 and a narrow end 508. After narrow end 508, waveguide 220 broadens out to a gain end 509 where the optical signal propagated by waveguide 220 enters gain 202. In the embodiment of Figure 5, wide end 506 is approximately 3 microns wide, narrow end 508 is approximately 1 micron wide, and gain end 509 is approximately 3 microns wide. In an alternative embodiment, wide end 506 may be greater than 3 microns wide.

Optical beam 126 enters wide end 506 of tapered waveguide section 504. Light from the external cavity has a larger beam size than light traveling in waveguide 220. Having a wide end in waveguide 220 facilitates collecting more light from the external cavity, but this may excite undesirable lasing modes in waveguide 220. The tapering filters out these undesirable modes. Additionally, since the optical mode shape coming from the tuner of cavity elements 103 will most likely subtend a wide cone angle of illumination, the mode filter provided by tapered waveguide section 504 will select only waveguide 220's fundamental optical mode and reject higher order modes excited by non-normal illumination.

The angle of incidence of optical beam 126 also affects the filtering affects of tapered waveguide section 504. This angle of incidence may also be referred to as waveguide tilt angle 514. Waveguide tilt angle 514 is measured from the normal 512 to front facet 516. In one embodiment, a waveguide tilt angle of approximately 7 degrees is used. A waveguide tilt angle of 7 degrees also reduces reflections at the facet interface back into the laser, which might produce laser instability.

Figures 5B and 5C show the affect of tapered waveguide section 504 in filtering out undesired modes. The horizontal axis of Figures 5B and 5C show the waveguide tilt angle and the vertical axis shows the output power of various modes in waveguide 220. The vertical axis is a relative scale of power from 0.0 to 1.0.

Figure 5B shows the affect of a straight waveguide of 3 microns. As shown in the graph, undesired modes 1 and 2 are excited within waveguide 220 across various launch angles.

Figure 5C shows the affect of a waveguide tapered from 3 microns to 1 micron, that is, wide end 506 is 3 microns and narrow end 508 is 1 micron. Modes 1 and 2 are essentially filtered out across various waveguide tilt angles. The desired mode, mode 0, has optimal power at a waveguide tilt angle of approximately 7 degrees.

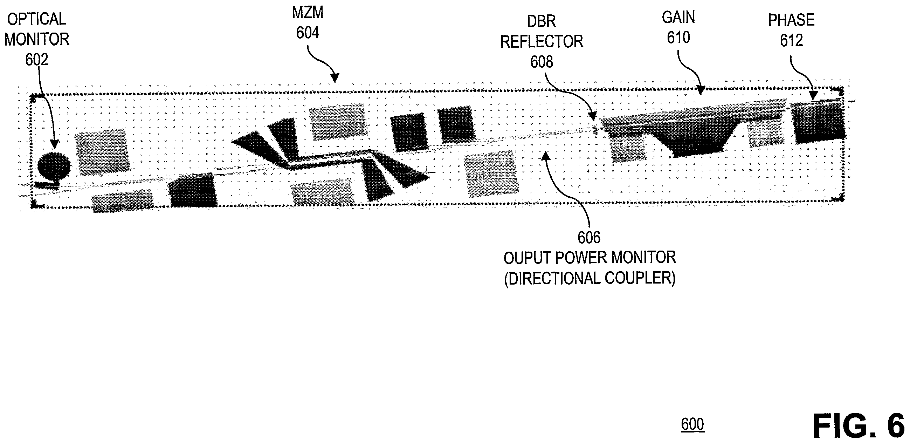

Referring to Figure 6, an embodiment of a mask layout 600 of an integrated structure is shown. Components shown in mask layout 600 include optical monitor 602, MZM 604, output power monitor 606, DBR reflector 608, gain section 610, and phase control section 612.

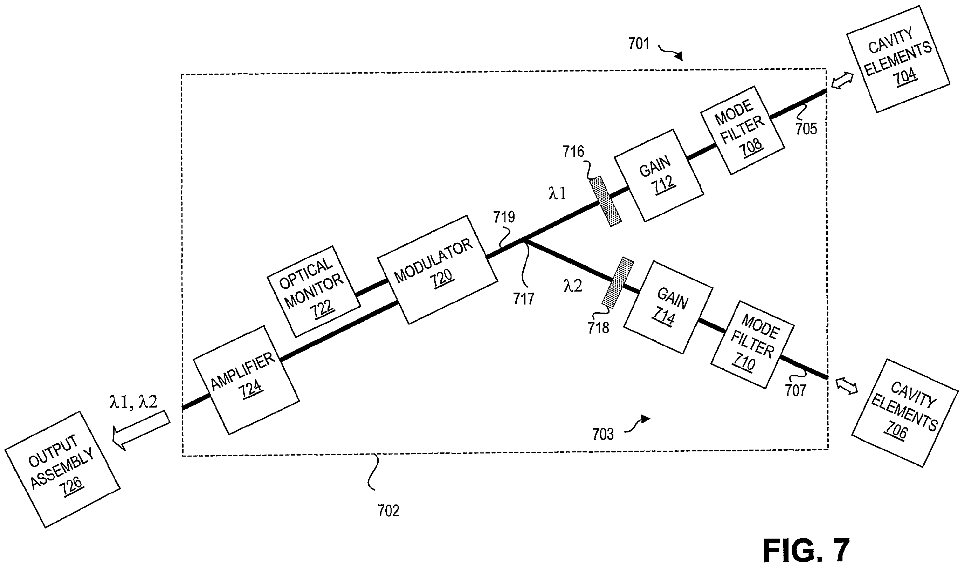

Referring to Figure 7, an embodiment of an integrated structure 702 is shown. Multiple wavelength broadcasting may be implemented using integrated structure 702 by incorporating two or more separate laser cavities with a common chip.

Laser 701 includes cavity elements 704 optically coupled to a waveguide 705. Laser 701 also includes mode filter 708, gain 712, and reflector 716 optically coupled by waveguide 705. Laser 701 produces an optical output at wavelength λ1.

Laser 703 includes cavity elements 706 optically coupled to a waveguide 707. Laser 703 also includes mode filter 710, gain 714, and reflector 718 optically coupled by waveguide 707. Laser 703 produces an optical output at wavelength λ2.

Waveguide 705 and 707 are coupled to waveguide 719 by optical coupler 717. After optical coupler 717, the optical signal including wavelengths λ1 and λ2 enters modulator 720.

In an embodiment using an MZM, all optical wavelengths are modulated simultaneously. MZM's are usually wavelength insensitive, so if the MZM is optimized for one particular wavelength, such as through bias voltage control, then the MZM will usually be optimized for all other wavelengths.

The output of modulator 720 is optically coupled to amplifier 724. A complementary output of modulator 720 is optically coupled to optical monitor 722 for bias control of modulator 720. The modulated optical signal having wavelengths λ1 and λ2 is output from integrated structure 702 into output assembly 726.

It will be appreciated that more than two wavelengths may be combined and modulated using an integrated structure as described above. Further, it will be understood that any combination of control sections, as described herein, may be utilized in integrated structure 702. Also, it is not necessary that each laser, such as laser 701 and 703, have the same combination of control sections.

Embodiments of the present invention provide laser functionality as well as monitoring and feedback mechanisms integrated onto a single semiconductor chip. Embodiments of the control section include a mode filter, an amplifier, a laser output power monitor, and an optical monitor for a modulator. Embodiments of a monolithically integrated structure described herein result in lower manufacturing costs and a small form factor with increased functionality.

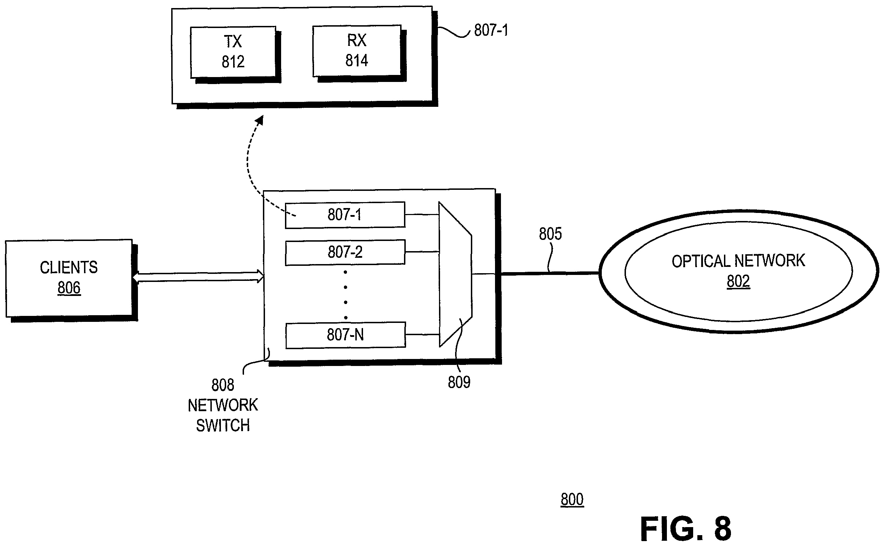

Referring to Figure 8, a system 800 in accordance with one embodiment of the present invention is shown. System 800 includes a network switch 808 coupled to an optical network 802 via optical link 805. In one embodiment, optical link 805 includes one or more optical fibers. Network switch 808 is also coupled to one or more clients 806. Embodiments of client 806 include a router, a server, a host computer, a phone system, or the like.

Network switch 808 includes transponders 807-1 to 807-N coupled to a multiplexer/demultiplexer 809. A transponder 807 converts between optical signals of optical network 802 and electrical signals used by clients 806. Multiplexer/demultiplexer 809 is a passive optical device that divides wavelengths (or channels) from a multi-channel optical signal, or combines various wavelengths (or channels) on respective optical paths into one multi-channel optical signal depending on the propagation direction of the light. In one embodiment, system 800 employs Wavelength Division Multiplexing (WDM), Dense Wavelength Division Multiplexing (DWDM), Frequency Division Multiple Access (FDMA), or the like.

Each transponder 807 may include an optical transmitter 812 and optical receiver 814. In one embodiment, optical transmitter 812 includes an integrated structure having a control section as described herein.

Various operations of embodiments of the present invention are described herein. These operations may be implemented by a machine using a processor, an Application Specific Integrated Circuit (ASIC), a Field Programmable Gate Array (FPGA), or the like. In one embodiment, one or more of the operations described may constitute instructions stored on a machine-readable medium, that when executed by a machine will cause the machine to perform the operations described. The order in which some or all of the operations are described should not be construed as to imply that these operations are necessarily order dependent. Alternative ordering will be appreciated by one skilled in the art having the benefit of this description. Further, it will be understood that not all operations are necessarily present in each embodiment of the invention.

The above description of illustrated embodiments of the invention, including what is described in the Abstract, is not intended to be exhaustive or to limit the embodiments to the precise forms disclosed. While specific embodiments of, and examples for, the invention are described herein for illustrative purposes, various equivalent modifications are possible, as those skilled in the relevant art will recognize. These modifications can be made to embodiments of the invention in light of the above detailed description.

## Claims

1. An apparatus, comprising:
an integrated structure (102; 702) including front (201) and rear (203) facets optically coupled by a waveguide (220;715) passing through the integrated structure, the integrated structure including:
a gain section (202;702) for emitting an optical output;
a reflector (208;716) optically coupled to the gain section by the waveguide;
a modulator (214;720) optically coupled to the reflector by the waveguide, the modulator to modulate the optical output; and
a control section disposed along the waveguide;
**characterised by**:
the control section comprising an optical amplifier (310) optically coupled between the gain section (202) and the modulator (214;720) by the waveguide,
wherein the optical amplifier (310) is operable to monitor a laser output from the gain section, and
wherein the control section is operable to adjust the gain section (202;712) to optimize an optical output power in dependence upon an output from said optical amplifier (310).

2. The apparatus of claim 1, wherein the optical amplifier (310) is operable to generate a voltage that is proportional to the optical output power of the gain section (202;712), and wherein the control section is further operable to use the generated voltage to evaluate an output power performance and to generate an optical power feedback signal to the gain section.

3. The apparatus of claim 1 wherein the control section further includes a mode filter (306) optically coupled between the gain section and the front facet by the waveguide.

4. The apparatus of claim 3 wherein the mode filter (306) includes a tapered waveguide section in the waveguide, wherein the tapered waveguide section has a wide end substantially co-planar with the front facet.

5. The apparatus of claim 1 wherein the optical amplifier (310) is further operable as an optical attenuator.

6. The apparatus of claim 1 wherein the optical amplifier (310) is further operable as an optical shutter.

7. The apparatus of claim 1 wherein the control section includes a further laser output monitor (312) optically coupled between the gain section (202) and the modulator (214) by the waveguide (220).

8. The apparatus of claim 7 wherein the further laser output monitor (312) includes a directional coupler, the directional coupler including a second waveguide disposed proximate to the waveguide, the second waveguide to tap off a portion of the optical output propagated by the waveguide.

9. The apparatus of claim 7 wherein the further laser output monitor (312) includes an in-line photodiode detector, a photodiode of the in-line photodiode detector being reversed biased to absorb a fraction of the optical output propagated by the waveguide.

10. The apparatus of claim 1 wherein the control section includes further optical monitor (316;722) coupled to a complementary output of the modulator (214;720) by a second waveguide (320).

11. The apparatus of claim 10 wherein the further optical monitor (316;722) is operable to filter to effectively average over data-rate variations of optical power.

12. The apparatus of claim 1 wherein the control section includes a further optical amplifier (318;724) optically coupled to an output of the modulator (214;720) by the waveguide (220).

13. The apparatus of claim 1, further comprising:
a second gain section (714);
a second reflector (718) coupled to the second gain section by a second waveguide (707), wherein the second waveguide is optically coupled to the waveguide at an optical coupler positioned between the reflector and the modulator.

14. A tunable laser, comprising:
cavity elements (103;704;706) including a reflector;
an output assembly (101;726); and
an apparatus (102;702) as set out in any one of claims 1 to 13, wherein the reflector (208;716) of the apparatus is a partial reflector optically coupled to the gain section (202;712) by the waveguide (220;715), the partial reflector to emit an optical output, the partial reflector and the reflector defining a laser cavity of the tunable laser.

15. The tunable laser of claim 14 wherein the cavity elements (103;704;706) are optically coupled to the integrated structure (102;702) to provide a waveguide tilt angle of light passing between the cavity elements and the waveguide.

16. The tunable laser of claim 14 wherein the control section of the apparatus includes a laser output monitor (312) to measure the optical output power of the tunable laser optically coupled between the gain section (202) and the modulator (214) by the waveguide (220), wherein the measured optical output power to be used in generating a feedback signal for at least one of the gain section, an amplifier optically coupled between the gain section and the modulator by the waveguide, or a phase control section optically coupled between the gain section and the front facet by the waveguide.

17. The tunable laser of claim 14 wherein the control section of the apparatus includes an optical power monitor (316;722) coupled to a complementary output of the modulator (214;720) by a second waveguide (320), the optical power monitor to recover a dither inputted into the modulator, the recovered dither to be used to adjust a bias voltage inputted into the modulator.

18. The tunable laser of claim 14 wherein the control section of the apparatus includes a further amplifier (318; 724) optically coupled to an output of the modulator (214; 720) by the waveguide.

19. A system, comprising:
an optical fiber (805); and
a switch (808) coupled to the optical fiber (805), the switch including a tunable laser as set out in any one of claims 14 to 18.

20. The system of claim 19, further comprising a controller (138) coupled to the optical amplifier (310) and the gain section (202;712), wherein the controller is operable to provide control signals to the gain section in response to output power of the optical output measured by the optical amplifier (310).

## Patentansprüche

1. Einrichtung, die umfasst:
eine integrierte Struktur (102; 702), die eine vordere (201) und eine hintere (203) Facette aufweist, welche mittels eines Wellenleiters (220; 715), der durch die integrierte Struktur verläuft, optisch gekoppelt sind, wobei die integrierte Struktur aufweist:
einen Verstärkungsbereich (202; 702) zum Emittieren eines optischen Ausgangs;
einen Reflektor (208; 716), der mittels des Wellenleiters optisch mit dem Verstärkungsbereich gekoppelt ist;
einen Modulator (214; 720), der mittels des Wellenleiters mit dem Reflektor gekoppelt ist, wobei der Modulator den optischen Ausgang moduliert; und
einen Steuerbereich, der den Wellenleiter entlang angeordnet ist;
**gekennzeichnet durch**:
den Steuerbereich, der einen optischen Verstärker (310) umfasst, welcher mittels des Wellenleiters optisch zwischen dem Verstärkungsbereich (202) und dem Modulator (214; 720) gekoppelt ist,
wobei der optische Verstärker (310) zum Überwachen eines Laserausgangs aus dem Verstärkungsbereich wirksam ist, und
wobei der Steuerbereich zum Einstellen des Verstärkungsbereichs (202; 712) zum Optimieren einer optischen Ausgangsleistung in Abhängigkeit von einem Ausgang aus dem optischen Verstärker (310) wirksam ist.

2. Einrichtung nach Anspruch 1, wobei der optische Verstärker (310) zum Erzeugen einer Spannung wirksam ist, die proportional zu der optischen Ausgangsleistung des Verstärkungsbereichs (202; 712) ist, und wobei der Steuerbereich ferner zum Verwenden der erzeugten Spannung zum Bewerten eines Ausgangsleistungsverhaltens und zum Erzeugen eines Rückkopplungssignals der optischen Leistung zu dem Verstärkungsbereich wirksam ist.

3. Einrichtung nach Anspruch 1, wobei der Steuerbereich ferner ein Modenfilter (306) aufweist, das mittels des Wellenleiters optisch zwischen dem Verstärkungsbereich und der vorderen Facette gekoppelt ist.

4. Einrichtung nach Anspruch 3, wobei der Modenfilter (306) einen konisch zulaufenden Wellenleiterbereich in dem Wellenleiter aufweist, wobei der konisch zulaufende Wellenleiterbereich ein breites Ende aufweist, das mit der vorderen Facette im Wesentlichen koplanar ist.

5. Einrichtung nach Anspruch 1, wobei der optische Verstärker (310) ferner als optischer Dämpfer wirksam ist.

6. Einrichtung nach Anspruch 1, wobei der optische Verstärker (310) ferner als optischer Verschluss wirksam ist.

7. Einrichtung nach Anspruch 1, wobei der Steuerabschnitt einen weiteren Laserausgangsmonitor (312) aufweist, der mittels des Wellenleiters (220) optisch zwischen dem Verstärkungsbereich (202) und dem Modulator (214) gekoppelt ist.

8. Einrichtung nach Anspruch 7, wobei der weitere Laserausgangsmonitor (312) einen Richtungskoppler aufweist, wobei der Richtungskoppler einen zweiten Wellenleiter aufweist, der nahe dem Wellenleiter angeordnet ist, wobei der zweite Wellenleiter einen Teil des optischen Ausgangs abgreift, der durch den Wellenleiter ausgebreitet wird.

9. Einrichtung nach Anspruch 7, wobei der weitere Laserausgangsmonitor (312) einen Reihen-Fotodiodendetektor aufweist, wobei eine Fotodiode des Reihen-Fotodiodendetektors in Sperrrichtung vorgespannt ist, um einen Teil des optischen Ausgangs, der durch den Wellenleiter ausgebreitet wird, zu absorbieren.

10. Einrichtung nach Anspruch 1, wobei der Steuerbereich einen weiteren optischen Monitor (316; 722) aufweist, der mittels eines zweiten Wellenleiters (320) mit einem komplementären Ausgang des Modulators (214; 720) gekoppelt ist.

11. Einrichtung nach Anspruch 10, wobei der weitere optische Monitor (316; 722) zum filtern zum effektiven Mitteln über Datenratenschwankungen der optischen Leistung wirksam ist.

12. Einrichtung nach Anspruch 1, wobei der Steuerbereich einen weiteren optischen Verstärker (318; 724) aufweist, der mittels des Wellenleiters (220) optisch mit einem Ausgang des Modulators (214; 720) gekoppelt ist.

13. Einrichtung nach Anspruch 1, die ferner umfasst:
einen zweiten Verstärkungsbereich (714);
einen zweiten Reflektor (718), der mittels eines zweiten Wellenleiters (707) mit dem zweiten Verstärkungsbereich gekoppelt ist, wobei der zweite Wellenleiter an einem optischen Koppler, der zwischen dem Reflektor und dem Modulator positioniert ist, optisch mit dem Wellenleiter gekoppelt ist.

14. Abstimmbarer Laser, der umfasst:
Resonatorelemente (103; 704; 706), einschließlich eines Reflektors;
eine Ausgangsanordnung (101; 726); und
eine Einrichtung (102; 702) nach einem der Ansprüche 1 bis 13, wobei der Reflektor (208; 716) der Einrichtung ein Teilreflektor ist, der mittels des Wellenleiters (220; 715) optisch mit dem Verstärkungsbereich (202; 712) gekoppelt ist, wobei der Teilreflektor einen optischen Ausgang emittiert, wobei der Teilreflektor und der Reflektor einen Laserresonator des abstimmbaren Lasers bilden.

15. Abstimmbarer Laser nach Anspruch 14, wobei die Resonatorelemente (103; 704; 706) optisch mit der integrierten Struktur (102; 702) gekoppelt sind, um einen Wellenleiterneigungswinkel des Lichts zu bilden, das zwischen den Resonatorelementen und dem Wellenleiter verläuft.

16. Abstimmbarer Laser nach Anspruch 14, wobei der Steuerbereich der Einrichtung einen Laserausgangsmonitor (312) zum Messen der optische Ausgangsleistung des abstimmbaren Lasers aufweist, der mittels des Wellenleiters (220) optisch zwischen dem Verstärkungsbereich (202) und dem Modulator (214) gekoppelt ist, wobei die gemessene optische Ausgangsleistung zum Erzeugen eines Rückkopplungssignals für mindestens einen des Verstärkungsbereichs, eines Verstärkers, der mittels des Wellenleiters optisch zwischen dem Verstärkungsbereich und dem Modulator gekoppelt ist, oder eines Phasensteuerbereichs, der mittels des Wellenleiters zwischen dem Verstärkungsbereich und der vorderen Facette gekoppelt ist, verwendet wird.

17. Abstimmbarer Laser nach Anspruch 14, wobei der Steuerbereich der Einrichtung einen Optische-Leistung-Monitor (316; 722) aufweist, der mittels eines zweiten Wellenleiters (320) mit einem komplementären Ausgang des Modulators (214; 720) gekoppelt ist; wobei der Optische-Leistung-Monitor eine Schwingung, die in den Modulator eingegeben wird, wiedergewinnt, wobei die wiedergewonnene Schwingung zum Einstellen einer Vorspannung verwendet wird, die in den Modulator eingegeben wird.

18. Abstimmbarer Laser nach Anspruch 14, wobei der Steuerbereich der Einrichtung einen weiteren Verstärker (318; 724) aufweist, der mittels des Wellenleiters optisch mit einem Ausgang des Modulators (214; 720) gekoppelt ist.

19. System, das umfasst:
eine optische Faser (805); und
einen Schalter (808), der mit der optischen Faser (805) gekoppelt ist, wobei der Schalter einen abstimmbaren Laser nach einem der Ansprüche 14 bis 18 aufweist.

20. System nach Anspruch 19, das ferner eine Steuerungseinrichtung (138) umfasst, die mit dem optischen Verstärker (310) und dem Verstärkungsbereich (202; 712) gekoppelt ist, wobei die Steuerungseinrichtung in Reaktion auf die Ausgangsleistung des optischen Ausgangs, die von dem optischen Verstärker (310) gemessen wird, zu liefern Steuersignale zu dem Verstärkungsbereich wirksam ist.

## Revendications

1. Appareil, comprenant :
une structure intégrée (102 ; 702) comportant des facettes avant (201) et arrière (203) optiquement couplées par un guide d'ondes (220 ; 715) traversant la structure intégrée, la structure intégrée comportant :
une section de gain (202 ; 702) servant à émettre une sortie optique ;
un réflecteur (208 ; 716) optiquement couplé à la section de gain par le guide d'ondes ;
un modulateur (214 ; 720) optiquement couplé au réflecteur par le guide d'ondes, le modulateur servant à moduler la sortie optique ; et
une section de contrôle disposée le long du guide d'ondes ;
**caractérisé par** :
la section de contrôle comprenant un amplificateur optique (310) optiquement couplé entre la section de gain (202) et le modulateur (214 ; 720) par le guide d'ondes,
dans lequel l'amplificateur optique (310) est utilisable pour surveiller une sortie laser de la section de gain, et
dans lequel la section de contrôle est utilisable pour ajuster la section de gain (202 ; 712) afin d'optimiser une puissance de sortie optique en fonction d'une sortie dudit amplificateur optique (310).

2. Appareil de la revendication 1, dans lequel l'amplificateur optique (310) est utilisable pour générer une tension qui est proportionnelle à la puissance de sortie optique de la section de gain (202 ; 712), et dans lequel la section de contrôle est également utilisable pour employer la tension générée pour évaluer une performance de puissance de sortie et pour générer un signal de retour de puissance optique à destination de la section de gain.

3. Appareil de la revendication 1 dans lequel la section de contrôle comporte en outre un filtre de mode (306) optiquement couplé entre la section de gain et la facette avant par le guide d'ondes.

4. Appareil de la revendication 3 dans lequel le filtre de mode (306) comporte une section de guide d'ondes conique dans le guide d'ondes, la section de guide d'ondes conique ayant une extrémité large sensiblement coplanaire avec la facette avant.

5. Appareil de la revendication 1 dans lequel l'amplificateur optique (310) est également utilisable comme atténuateur optique.

6. Appareil de la revendication 1 dans lequel l'amplificateur optique (310) est également utilisable comme obturateur optique.

7. Appareil de la revendication 1 dans lequel la section de contrôle comporte un autre moniteur de sortie laser (312) optiquement couplé entre la section de gain (202) et le modulateur (214) par le guide d'ondes (220).

8. Appareil de la revendication 7 dans lequel l'autre moniteur de sortie laser (312) comporte un coupleur directionnel, le coupleur directionnel comportant un deuxième guide d'ondes disposé à proximité du guide d'ondes, le deuxième guide d'ondes servant à recueillir une partie de la sortie optique propagée par le guide d'ondes.

9. Appareil de la revendication 7 dans lequel l'autre moniteur de sortie laser (312) comporte un détecteur à photodiodes en ligne, une photodiode du détecteur à photodiodes en ligne étant inversement polarisée pour absorber une fraction de la sortie optique propagée par le guide d'ondes.

10. Appareil de la revendication 1 dans lequel la section de contrôle comporte un autre moniteur optique (316 ; 722) couplé à une sortie complémentaire du modulateur (214 ; 720) par un deuxième guide d'ondes (320).

11. Appareil de la revendication 10 dans lequel l'autre moniteur optique (316 ; 722) est utilisable pour filtrer afin de moyenner efficacement sur les variations de débit de données de puissance optique.

12. Appareil de la revendication 1 dans lequel la section de contrôle comporte un autre amplificateur optique (318 ; 724) optiquement couplé à une sortie du modulateur (214 ; 720) par le guide d'ondes (220).

13. Appareil de la revendication 1, comprenant en outre :
une deuxième section de gain (714) ;
un deuxième réflecteur (718) couplé à la deuxième section de gain par un deuxième guide d'ondes (707), le deuxième guide d'ondes étant optiquement couplé au guide d'ondes au niveau d'un coupleur optique positionné entre le réflecteur et le modulateur.

14. Laser accordable, comprenant :
des éléments de cavité (103 ; 704 ; 706) comportant un réflecteur ;
un ensemble de sortie (101 ; 726) ; et
un appareil (102 ; 702) tel que défini dans l'une quelconque des revendications 1 à 13, le réflecteur (208 ; 716) de l'appareil étant un réflecteur partiel optiquement couplé à la section de gain (202 ; 712) par le guide d'ondes (220 ; 715), le réflecteur partiel servant à émettre une sortie optique, le réflecteur partiel et le réflecteur définissant une cavité laser du laser accordable.

15. Laser accordable de la revendication 14 dans lequel les éléments de cavité (103 ; 704 ; 706) sont optiquement couplés à la structure intégrée (102 ; 702) pour appliquer un angle d'inclinaison de guide d'ondes à la lumière passant entre les éléments de cavité et le guide d'ondes.

16. Laser accordable de la revendication 14 dans lequel la section de contrôle de l'appareil comporte un moniteur de sortie laser (312) pour mesurer la puissance de sortie optique du laser accordable optiquement couplé entre la section de gain (202) et le modulateur (214) par le guide d'ondes (220), la puissance de sortie optique mesurée devant être utilisée pour générer un signal de retour pour au moins un élément parmi la section de gain, un amplificateur optiquement couplé entre la section de gain et le modulateur par le guide d'ondes, ou une section de contrôle de phase optiquement couplée entre la section de gain et la facette avant par le guide d'ondes.

17. Laser accordable de la revendication 14 dans lequel la section de contrôle de l'appareil comporte un moniteur de puissance optique (316 ; 722) couplé à une sortie complémentaire du modulateur (214 ; 720) par un deuxième guide d'ondes (320), le moniteur de puissance optique servant à récupérer un signal de superposition entré dans le modulateur, le signal de superposition récupéré devant être utilisé pour ajuster une tension de polarisation entrée dans le modulateur.

18. Laser accordable de la revendication 14 dans lequel la section de contrôle de l'appareil comporte un autre amplificateur (318 ; 724) optiquement couplé à une sortie du modulateur (214 ; 720) par le guide d'ondes.

19. Système, comprenant :
une fibre optique (805) ; et
un commutateur (808) couplé à la fibre optique (805), le commutateur comportant un laser accordable tel que défini dans l'une quelconque des revendications 14 à 18.

20. Système de la revendication 19, comprenant en outre un contrôleur (138) couplé à l'amplificateur optique (310) et à la section de gain (202 ; 712), dans lequel le contrôleur est utilisable pour délivrer des signaux de commande à la section de gain en réponse à la puissance de sortie de la sortie optique mesurée par l'amplificateur optique (310).
